# FASCICULE DE BREVET EUROPEEN

(11) **EP 1 190 377 B1**
(45) Date de publication et mention de la délivrance du brevet: **02.04.2003**
(21) Numéro de dépôt: 00925432.7
(22) Date de dépôt: 11.05.2000
(51) Int. Cl.: G06K 19/077

(54) **PROCEDE DE FABRICATION DE DISPOSITIF ELECTRONIQUE PORTABLE A CIRCUIT INTEGRE COMPORTANT UN DIELECTRIQUE BAS COUT**
VERFAHREN ZUR HERSTELLUNG EINER TRAGBAREN ELEKTRONISCHEN ANORDNUNG MIT EINER INTEGRIERTEN SCHALTUNG MIT KOSTENGÜNSTIGEM DIELEKTRICUM
METHOD FOR THE PRODUCTION OF A PORTABLE INTEGRATED CIRCUIT ELECTRONIC DEVICE COMPRISING A LOW-COST DIELECTRIC

(30) Priorité: 25.05.1999 FR 9906585
(43) Date de publication de la demande: 27.03.2002
(73) Titulaire: Gemplus, 13881 Gémenos Cedex (FR)
(72) Inventeur: DOSSETTO, Lucille, F-13600 La Ciotat (FR)
(74) Mandataire: Scheer, Luc
(86) Numéro de dépôt international: FR0001268
(87) Numéro de publication internationale: WO00072254

(56) Documents cités:
- EP-A- 0 246 744
- EP-A- 0 688 050
- EP-A- 0 774 779
- EP-A- 0 813 166
- WO-A-96/34361
- DE-A- 19 621 044
- US-A- 4 879 153

## Description

L'invention concerne la fabrication d'un dispositif électronique portable à puce reliée à des bornier de connexion et/ou par une antenne d'interface.

Ces dispositifs sont par exemple des cartes à puce ou des étiquettes électroniques.

Ils sont destinés à la réalisation d'opérations par exemple bancaires, téléphoniques, d'identification ou télé billettique.

Les cartes à contact comportent des métallisations disposées à un endroit précis défini par la norme ISO 7816.

Les cartes sans contact comportent une antenne permettant d'échanger des informations avec l'extérieur grâce à un couplage électromagnétique par radiofréquence ou hyperfréquence.

Il existe également des cartes hybrides ou "combicards".

Actuellement, les dispositifs portables ont de faibles épaisseur et dimensions normalisées par ISO 7810 (85 mm de longueur, de 54 mm de largeur et de 0.76 mm d'épaisseur).

La majorité des fabrications de cartes est basée sur l'assemblage d'un sous-ensemble appelé micromodule qui est relié à une interface de communication et encarté, c'est à dire reporté et fixé dans une cavité du corps de carte.

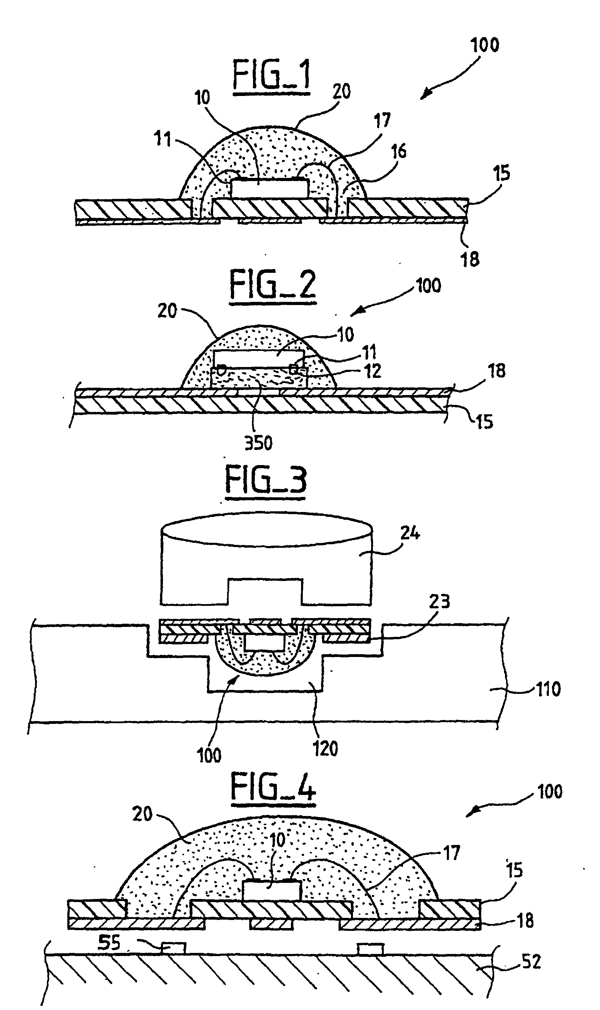

Une technique de fabrication illustrée sur la figure 1 consiste à coller une puce 10 en disposant sa face active avec ses plots de contact 11 vers le haut, et en collant sa face opposée sur un support diélectrique 15 en feuille. Le support diélectrique 15 est disposé sur une grille de contact 18 telle qu'une plaque métallique en cuivre nickelé et doré. Des puits de connexion 16 sont pratiqués dans le support diélectrique 15 afin de permettre à des fils de connexion 17 de relier les plots 11 aux plages de la grille 18.

Selon certaines variantes, la puce 10 est collée face active vers le haut, directement sur la grille 18.

La grille 18 est définie par gravure chimique.

Une étape de protection ou encapsulation vient ensuite enrober la puce 10 et ses fils de connexion 17, par une technique appelée « glob top » qui consiste à verser une goutte de résine 20 à base d'époxy thermodurcissable ou à réticulation aux ultraviolets.

La figure 2 illustre une technique dans laquelle la puce 10 est connectée à la grille 18 en « flip chip» avec la puce retournée et connectée à la grille métallique 18 au moyen d'une colle 350 à conduction électrique anisotrope. Les plots de sortie 11 sont placés en vis à vis des plages de la grille 18. Cette colle 350 permet d'établir une conduction électrique suivant l'axe z (c'est à dire suivant l'épaisseur) lorsqu'elle est pressée, tout en assurant une isolation suivant les autres directions (x,y).

La connexion de la puce 10 peut être améliorée par des bossages 12, en alliage thermofusible de type Sn / Pb ou en polymère conducteur, réalisés sur ses plots 11.

Pour constituer un micromodule 100, le support diélectrique 15 avec la puce 10 collée et protégée est découpé.

Dans le cas d'une carte à contact, le micromodule 100 est encarté par dépôt d'une colle liquide dans la cavité avant report.

Sur la figure 3 l'encartage est réalisé avec un film adhésif thermoactivable 23 déposé par lamination à chaud sur le support 15 avant la découpe du micromodule 100. Ce dernier est encarté dans la cavité 120 du corps de carte 110 et collé en réactivant l'adhésif thermoactivable 23 par pressage à chaud au moyen d'une presse 24.

Ces techniques présentent des inconvénients.

Elles nécessitent un grand nombre d'opérations.

Il est généralement nécessaire de fraiser la résine de protection pour adapter sa forme et son épaisseur, ce
qui est coûteux et stressant pour la puce.

Des techniques coûteuses utilisent un diélectrique haut de gamme, généralement en composite de verre époxy ou en kapton pour présenter une bonne tenue à la température d'encartage.

De plus, la gravure chimique est une opération onéreuse.

Dans une carte sans contact ou une étiquette électronique, le micromodule 100 est connecté à une antenne 55, comme sur la figure 4.

L'antenne 55 est réalisée sur un support isolant 52 constitué par du PVC ou du PE (Polychlorure de Vinyle, Poly Éthylène) ou autres.

L'antenne 55 est réalisée dans un matériau conducteur, en bobine, par sérigraphie d'encre conductrice ou par gravure chimique d'un métal déposé sur un support isolant. Elle peut présenter la forme d'une spirale.

La connexion entre l'antenne 55 et la grille 18 peut être réalisée par soudure étain/plomb, collage conducteur ou lamination.

Le corps de carte est alors réalisé par lamination à chaud de films plastiques ou par coffrage d'une résine entre les deux feuilles diélectriques 15 et 52 séparées par une entretoise.

Une étiquette électronique est réalisée par moulage d'un corps autour de l'électronique, par lamination de films plastiques ou par insertion dans un boîtier plastique.

Ces techniques présentent des inconvénients outre ceux cités précédemment.

Ainsi, la protection de la puce est délicate par encapsulation étant donné la densité de module sur la bande 52, ce qui oblige à réaliser un surmoulage du micromodule.

L'invention vise à pallier ces inconvénients.

A cet effet, l'invention est définie dans les revendications et en particulier dans les revendications indépendantes 1 et 18.

En outre, l'invention simplifie la connexion en réalisant une grille métallique cambrée de manière à placer les plots de la puce en vis à vis des plages de connexion de la grille.

Citons ici des documents à rapprocher de l'invention.

Le document EP-A-0688050 décrit une carte à puces sans module. Un logement est réalisé dans le corps, et une une grille métallique y est appliquée par emboutissage, métallisation à l'autoclave ou lithographie. Le logement possède des dimensions permettant de recevoir la puce et ses plots de contact. Ces plots sont placés en vis à vis et en liaison avec les plages de connexion de la grille métallique.

Le document EP-A-0813166 reflète le préambule des revendications indépendantes 1 et 18 et décrit des cartes à puces où un logement est réalisé dans une grille métallique. Ce logement possède des dimensions permettant de recevoir la puce et ses plots de contact.

Un conditionnement en résine en capsule la puce, ses connexions et laisse à fleur des contacts.

Le document WO-A-9634361 décrit le contre collage de bandes diélectriques et conductrices pour former des grilles pour carte à puce.

L'invention permet d'obtenir micromodule de faible épaisseur avec une bonne tenue à l'humidité et d'utiliser un diélectrique bas de gamme car ce dernier
ne requière pas de compatibilité avec l'encartage.

En effet, ce diélectrique ne couvre pas les plages de contact. Or, ce sont ces zones qui sont pressées ou collées avec une colle de type cyanoacrylate.

L'invention peut être réalisée en ligne sans interruption.

De plus, les étapes d'encapsulation et de fraisage sont supprimées, car la protection de la puce est assurée par la grille et un film laminé sur toute la surface de la grille.

D'autres avantages de l'invention apparaîtront dans la description d'exemples en référence aux figures annexées dans lesquelles :
- la figure 1 est un schéma en coupe transversale illustrant un procédé traditionnel de fabrication d'un micromodule ;
- la figure 2 est un schéma en coupe transversale illustrant un procédé traditionnel de fabrication d'un micromodule avec une variante de réalisation dans la connexion de la puce ;
- La figure 3 illustre schématiquement l'encartage d'un micromodule selon un procédé connu ;
- La figure 4 illustre schématiquement le report d'un micromodule sur une antenne selon un procédé connu ;
- La figure 5 est un schéma en coupe transversale d'un premier mode de réalisation du procédé de fabrication selon l'invention ;
- La figure 6 est un schéma en coupe transversale d'un deuxième mode de réalisation du procédé de fabrication selon l'invention ;
- La figure 7 illustre schématiquement l'encartage d'un micromodule selon le procédé de l'invention ;
- La figure 8 est une vue schématique de dessous, côté assemblage, du micromodule obtenu par le procédé selon l'invention ;
- La figure 9 est une vue schématique de dessus, côté contacts, du micromodule obtenu par le procédé selon l'invention ;
- La figure 10 est un diagramme schématique des étapes de fabrication d'un micromodule selon l'invention ;
- La figure 11 est une vue schématique de dessus d'un troisième mode de réalisation du procédé de fabrication selon l'invention ;
- La figure 12 est un schéma en coupe transversale du report d'un micromodule selon l'invention sur une antenne de sérigraphie.

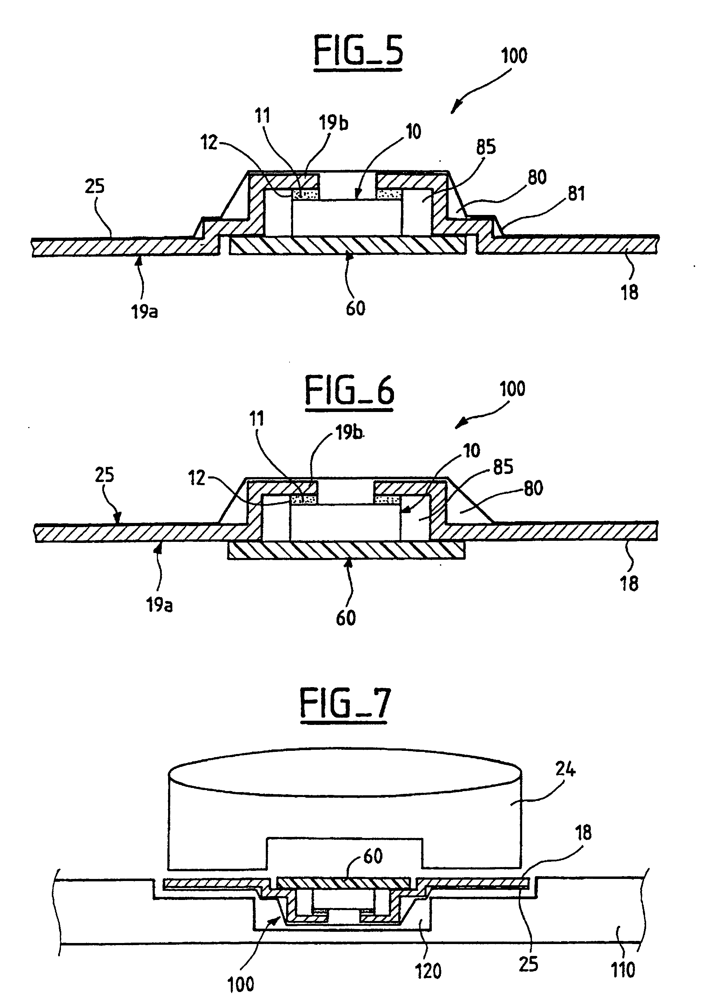

Les figures 5 et 6 illustrent un premier et deuxième mode de réalisation d'un micromodule selon l'invention.

Ces deux premiers modes de réalisation s'appliquent aux cartes à puce à contact.

Une puce 10 de circuit intégré est collée sur une bande diélectrique 60 laminée sur une grille métallique 18 cambrée une ou deux fois, une première fois pour encaisser l'épaisseur de la puce 10 et de ses plots de contact 11 de manière à mettre les plages de connexion 19b de la grille 18 en face des plots de contacts 11 de la puce 10, et une seconde fois pour encaisser l'épaisseur de la bande diélectrique 60 de manière à mettre cette dernière à fleur des plages de contacts 19a de la grille 18.

Par exemple, des bossages 12 ont préalablement été réalisés sur chaque plot de contact 11 de la puce 10. Ces bossages 12 sont destinés à améliorer la connexion électrique entre les plots de contact 11 de la puce 10 et les plages de connexion 19b de la grille 18. Ils sont par conséquent nécessairement réalisés dans un matériau conducteur, comme par exemple de l'or, ou dans un matériau polymère chargé en particules métalliques.

Un film de protection 25, présentant des propriétés adhésives ré activables est laminé sur toute la surface de la grille 18. Ce film 25 n'est pas perforé, comme c'était le cas dans l'art antérieur, pour laisser la puce 10 et ses connexions libres.

Le procédé de fabrication selon l'invention comprend au moins les étapes suivantes.

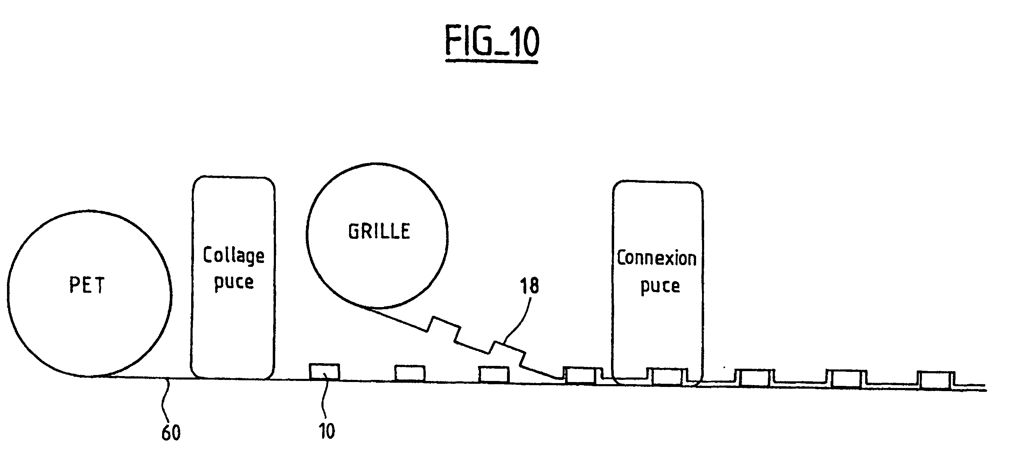

Ces étapes sont illustrées schématiquement sur le diagramme de la figure 10.

Un matériau isolant bas coût est découpé en bande. Ce diélectrique 60 peut être constitué de PET (Polyéthylène Téréphtalate), de PEN (Polyéthylène Néréphtalate), de papier, de ABS (Acrylonitrile Butadiène Styrène), de PVC (Polychlorure de Vinyle), ou de tout autre matériau isolant bas coût.

La bande diélectrique 60 peut avantageusement comporter une face adhésive non conductrice apte à recevoir le collage de la puce 10.

Lors de la découpe du diélectrique 60 en bande, des trous de repérage au pas du motif (par exemple 9,5 mm) sont réalisés pour servir, par la suite, au collage de la puce 10 avec précision.

Selon les variantes de réalisation, les trous de repérage peuvent être remplacés par dès mires préalablement imprimées sur le diélectrique 60.

La puce 10 est alors collée sur le diélectrique 60 avec précision au pas du motif choisi.

Selon les variantes, l'adhésif de la bande diélectrique 60 est thermoactivable pour un collage de la puce 10 à chaud ou est composé d'un « tack » qui désigne un adhésif à température ambiante pour un collage de la puce 10 à froid.

Il est également possible de réaliser un dépôt de colle sur le diélectrique 60 et de coller la puce 10 sur ce dépôt de colle.

La précision du collage sera assurée par le repérage des trous et/ou des mires préalablement réalisés sur la bande diélectrique 60.

Parallèlement, une grille métallique 18 est réalisées à base d'un alliage de cuivre par exemple, et recouverte d'un dépôt électrolytique adapté au type de connexion que l'on souhaite réaliser, par exemple de l'Or ou du Nickel.

Selon une particularité de l'invention, cette grille 18 est cambrée une ou deux fois selon des méthodes de cambrage classiques, par un poinçon par exemple.

Dans la variante de réalisation illustrée sur la figure 5, la grille est cambrée deux fois.

Une première cambrure 80 est destinée à encaisser la hauteur de la puce 10 et de ses bossages 12 afin de venir placer en vis à vis les plages de connexion 19b de la grille 18 et les bossages 12.

Une seconde cambrure 81 est destinée à encaisser la marche de la bande diélectrique 60 de manière à obtenir un micromodule 100 parfaitement plat du côté des contacts 19a. Ainsi, le diélectrique 60 est à fleur des plages de contact 19a de la grille 18 tout en laissant ces dernières dégagées de manière à assurer la communication du circuit vers l'extérieur.

La variante de réalisation illustrée sur la figure 6 ne présente que la première cambrure 80.

La grille 18 et le diélectrique 60 sont ensuite laminés.

La seconde cambrure 81 facilite la lamination du diélectrique 60 sur la grille 18 en constituant un guide pour la bande diélectrique 60.

La lamination, réalisée à l'aide des repères de la bande diélectrique 60 et/ou à l'aide de la seconde cambrure 81, vient mettre face à face les plages de connexions 19b de la grille 18 avec les plots de contact 11 éventuellement munis des bossages 12 de la puce 10.

Il est à noter que la puce 10, venant se connecter par dessous la grille 18, les plages de contact 19a de la grille 18 seront directement en correspondance, via les plages de connexion 19b, avec les plots 11 de la puce 10. Il ne se posera par conséquent pas le problème de devoir réaliser un motif adapté et complexe comme c'est le cas dans les connexions selon les procédés de « flip chip ».

Il est ensuite nécessaire de réaliser les connexions des plots 11 de la puce 10 aux plages de connexion 19b de la grille 18.

A cette fin, différents procédés connus peuvent être utilisés, comme par exemple des procédés de soudure laser ou de dépôt d'un adhésif anisotropique ou par un procédé de thermo compression ou par activation des bossages polymères conducteurs préalablement déposés sur les plots de contact 11 de la puce 10.

Il est avantageux, comme cela a déjà été exposé en référence à l'art antérieur, de laminer un adhésif 25 ré activable à chaud ou à la pression sur toute la largeur utile de la grille 18.

Avantageusement, l'adhésif 25 présente des propriétés isolantes pour constituer une protection supplémentaire de la puce 10. En effet,. l'adhésif 25 n'est pas perforé comme c'était systématiquement le cas dans l'art antérieur.

Le dépôt d'une résine de protection sur la puce 10 peut donc être totalement exclu grâce à l'invention.

Le micromodule 100 est alors découpé à l'aide d'un poinçon matrice ou d'un faisceau laser, puis reporté dans la cavité d'un corps de carte en . réactivant l'adhésif 25 ou en déposant une goutte de colle de type cyanoacrylate par exemple dans la cavité.

La figure 7 illustre l'étape d'encartage du micromodule 100 dans la cavité 120 du corps de carte 100, par la technique du pressage à chaud pour réactiver l'adhésif 25.

Cette figure montre clairement que le pressage à chaud ne s'applique pas au diélectrique 60, mais uniquement à la grille métallique 18, le poinçon 24
Qui comporte un évidemment correspondant au diélectrique 60.

De même, si une technique de report avec une colle de type cyanoacrylate avait été choisie, la colle aurait été appliquée entre la cavité 120 du corps de carte 100 et la grille métallique 18 couverte ou non de l'adhésif 25, et non sur le diélectrique 60.

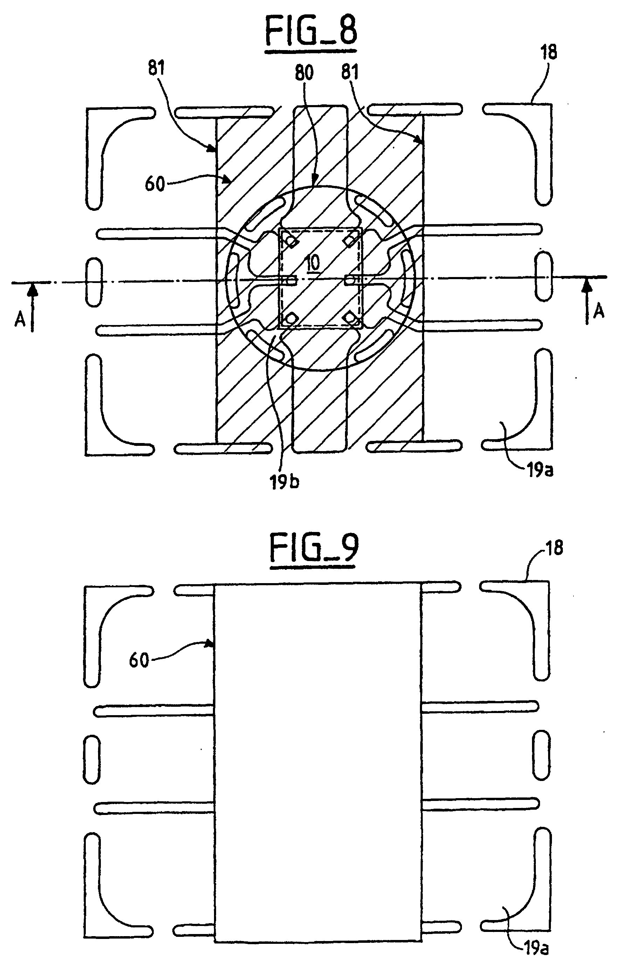

Les Figure 8 et 9 illustrent respectivement des vues schématiques de dessous et de dessus du micromodule obtenu selon l'invention appliqué aux cartes à contact.

Les figures 5 et 6 sont des coupes A-A de la figure 8.

La figure 8 montre clairement les cambrures 80 et 81 de la grille métallique 18, la première délimitant les plages de contact 19a et les plages de connexion 19b, et la seconde délimitant éventuellement la zone de la bande diélectrique 60.

La figure 9 montre le côté extérieur du micromodule, du côté des contacts ISO.

Selon une des variantes, exposée précédemment, la- bande diélectrique 60 est à fleur des plages de contact 19a de la grille métallique 18. L'extérieur de la carte à puce ainsi obtenue est donc parfaitement plat.

Dans l'autre variante, la bande diélectrique 60 formera une petite marche sur le dessus des plages de contact 19a.

En outre, le bornier de connexion 18 de la carte à puce obtenue présente une zone médiane correspondant à la bande diélectrique 60 sur laquelle un logo ou un dessin peut être imprimé (par exemple directement lors de la découpe du matériau isolant en bande.) Cette face de la bande diélectrique 60 pourra
être de couleurs différentes et/ou porter le numéro de série de la carte.

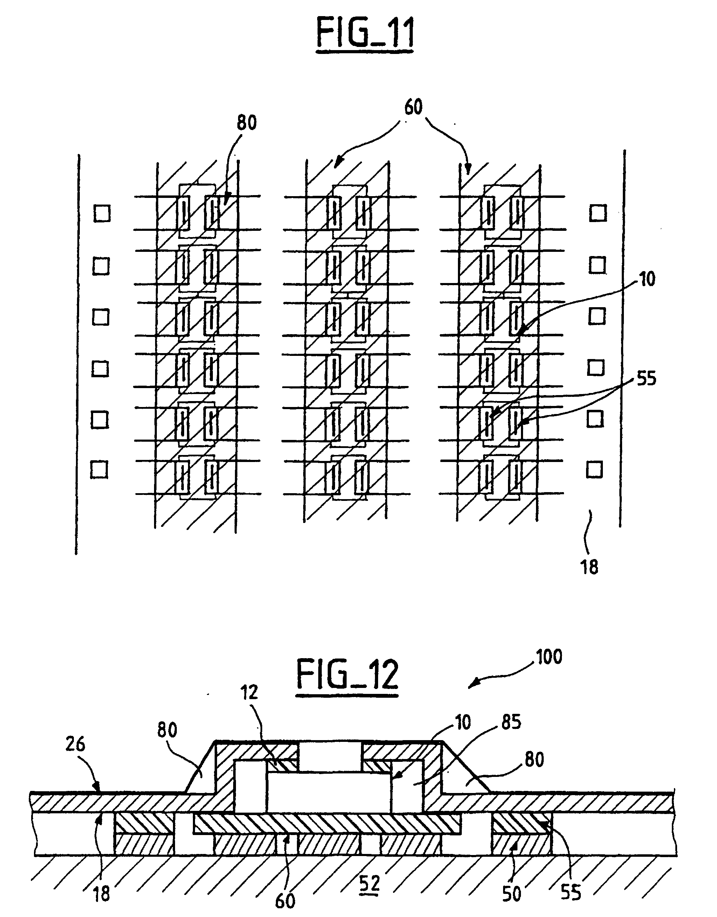

Les figures 11 et 12 illustrent un troisième mode de réalisation d'un micromodule selon l'invention qui s'applique aux cartes sans contact ou aux étiquettes électroniques.

Les figures 11 et 12 illustrent respectivement des vues de dessus et en coupe transversale du procédé de fabrication selon ce troisième mode de réalisation de l'invention.

Le procédé décrit précédemment pour les cartes à contact est repris, l'opération de lamination de la grille cambrée 18 sur le diélectrique 60 étant d'autant plus aisée que le nombre de plots de contact 11 de la puce 10, avec ou sans bossage 12, à connecter aux plages de connexion 19b est de deux seulement.

Par ailleurs, la protection de la puce 10 est obtenue par la lamination d'un film plein 26 sur toute la surface du micromodule 100. On s'affranchit ainsi de tous les problèmes de l'art antérieur liés au dépôt d'une goutte de résine pour une protection par encapsulation ou de surmoulage.

De plus, comme cela est illustré sur la figure 11, il est possible, dans le cadre de cette application, de laminer autant de bandes diélectriques 60 que possible pour optimiser le nombre de micromodules sur une grille 18.

La figure 12 illustre la connexion du micromodule 100 une antenne 50, réalisée selon des techniques standards.

Avantageusement, le diélectrique 60 peut servir à isoler les contacts 55 des autres spires de l'antenne 50, dans le cas d'une antenne de sérigraphie. Cela permet d'éviter la sérigraphie d'un isolant sur les spires centrales.

## Revendications

1. Procédé de fabrication d'un dispositif électronique portable à puce de circuit intégré (10) reportée sur un support diélectrique (60) et connectée à une grille métallique (18) qui comporte des plages de contact (19a) et des plages de connexion (19b) ; ce procédé comporte une étape consistant à réaliser un logement (85) de puce (10) sur une grille métallique (18) par cambrure (80) ; ce logement (85) ayant des dimensions permettant de recevoir l'épaisseur de la puce (10) et de ses plots de contact (11) pour que ces derniers soient affleurants ; la grille (18) est laminée sur le support diélectrique (60) de manière à placer chaque plot de contact (11) de la puce (10) en vis à vis et en liaison avec les plages de connexion (19b) de la grille (18) ; ce procédé étant **caractérisé en ce qu'**il est réalisé en ligne sans interruption, la puce (10) étant disposée sur le support diélectrique en bande pour former un ensemble ; puis cet ensemble est laminé sur la grille métallique (18) en bande, de sorte que la protection de la puce (10) soit assurée par la grille (18) et le support (60) laminé.

2. Procédé de fabrication selon la revendication 1, **caractérisé en ce que** le support diélectrique (60) est constitué d'une bande laissant les plages de contact (19a) de la grille métallique (18) dégagées.

3. Procédé de fabrication selon la revendication 2 **caractérisé en ce que** la grille métallique (18) présente en outre une seconde cambrure (81) apte à encaisser l'épaisseur de la bandé diélectrique (60) de manière à placer cette dernière à fleur des plages de contact (19a) de la grille métallique (18).

4. Procédé de fabrication selon l'une des revendications 1 à 3, **caractérisé en ce que** la bande diélectrique (60) est constitué d'un polyéthylène Téréphtalate (PET).

5. Procédé de fabrication selon l'une des revendications 1 à 3, **caractérisé en ce que** la bande diélectrique (60) est constitué d'un Acrylonitrile Butadiène Styrène (ABS).

6. Procédé de fabrication selon l'une des revendications 1 à 3, **caractérisé en ce que** la bande diélectrique (60) est constitué de papier.

7. Procédé de fabrication selon l'une des revendications 1 à 3, **caractérisé en ce que** la bande diélectrique (60) est constitué d'un Polychlorure de Vinyle (PVC).

8. Procédé de fabrication selon l'une des revendications précédentes, **caractérisé en ce que** la bande diélectrique (60) comporte une surface adhésive apte à assurer le collage de la puce (10) sur la bande (60).

9. Procédé de fabrication selon l'une des revendications précédentes, **caractérisé en ce que** des trous de repérages et/ou des mires sont réalisés sur la bande diélectrique (60) de manière à effectuer un collage précis de la puce (10) sur la bande (60).

10. Procédé de fabrication selon l'une des revendications 1 à 9, **caractérisé en ce que** la connexion des plots de contact (11) de la puce (10) aux plages de connexion (19b) de la grille (18) est réalisée par soudure laser.

11. Procédé de fabrication selon l'une des revendications 1 à 9, des bossages en matériau polymère conducteur étant déposés sur les plots de contact (11) de la puce (10), **caractérisé en ce que** la connexion des plots de contact (11) de la puce (10) aux plages de connexion (19b) de la grille (18) est réalisée par lamination à chaud.

12. Procédé de fabrication selon l'une des revendications 1 à 11, **caractérisé en ce qu'**il comporte une étape de report du micromodule (100) dans la cavité d'un corps de carte.

13. Procédé de fabrication selon la revendication 12, **caractérisé en ce que** le report du micromodule (100) est réalisé par activation d'un film adhésif (25) préalablement laminé sur la surface de la grille métallique (18).

14. Procédé de fabrication selon la revendication 13, **caractérisé en ce que** le film adhésif (25) constitue en outre un isolant assurant la protection de la puce (10).

15. Procédé de fabrication selon l'une des revendications 1 à 11, **caractérisé en ce qu'**il comporte une étape de connexion du micromodule (100) à une antenne (50).

16. Procédé de fabrication selon la revendication 15, **caractérisé en ce que** la puce (10) est protégée par lamination d'un film isolant (26) sur toute la surface de la grille métallique (18).

17. Procédé de fabrication selon la revendication 15, **caractérisé en ce que** le dispositif est fabriqué avec antenne (50) à spires centrales dont l'isolation des spires centrales est assurée par la bande diélectrique (60).

18. Module électronique à circuit intégré, comportant une puce de circuit intégré (10) reportée sur un support diélectrique (60) et connectée à une grille métallique (18) qui comporte des plages de contact (19a) et des plages de connexion (19b) ; ce module comportant un logement (85) de puce (10) sur une grille métallique (18) réalisé par cambrure (80) ; ce logement (85) ayant des dimensions permettant de recevoir l'épaisseur de la puce (10) et de ses plots de contact (11) pour que ces derniers soient affleurants ; la grille (18) étant laminée sur le support diélectrique (60) de sorte que chaque plot de contact (11) de la puce (10) est en vis à vis et en liaison avec les plages de connexion (19b) de la grille (18) ; **caractérisé en ce que** la puce (10) est disposée sur le support diélectrique en formant un ensemble ; cet ensemble étant laminé sur la grille métallique (18) en bande, de sorte que la protection de la puce (10) est assurée par la grille (18) et le support (60) laminé.

19. Module électronique selon la revendication 18, **caractérisé en ce que** le support diélectrique (60) est constitué d'une bande laissant les plages de contact (19a) dégagées.

20. Module électronique selon la revendication 19, **caractérisé en ce que** la grille métallique (18) présente deux cambrures distinctes, une première cambrure (80) encaissant l'épaisseur de la puce (10) et de ses plots de contact (11), et une deuxième cambrure (81) encaissant l'épaisseur de la bande diélectrique (60).

21. Module électronique selon l'une des revendications 18 à 20, **caractérisé en ce qu'**un film de protection (25) est disposé sur toute la surface de la grille métallique (18).

22. Dispositif portable à circuit intégré tel qu'une carte à puce, une étiquette électronique comprenant un module électronique selon l'une des revendications 18 à 21.

## Claims

1. A method of manufacturing a portable electronic device with an integrated-circuit chip (10) attached to a dielectric support (60) and connected to a metallic grille (18) which comprises contact areas (19a) and connection areas (19b); this method comprises a step consisting of producing a housing (85) for a chip (10) on a metallic grille (18) by curvature (80); this housing (85) having dimensions making it possible to receive the thickness of the chip (10) and its contact pads (11) so that the latter are flush; the grille (18) is laminated on the dielectric support (60) so as to place each contact pad (11) on the chip (10) facing and in connection with the connection areas (19b) of the grille (18); this method being **characterised in that** it carried out on the production line without interruption, the chip (10) being disposed on the dielectric support in strip form in order to form an assembly; then this assembly is laminated on the metallic grille (18) in strip form, so that the protection of the chip (10) is provided by the grille (18) and the laminated support (60).

2. A manufacturing method according to Claim 1, **characterised in that** the dielectric support (60) consists of a strip leaving the contact areas (19a) of the metallic grille (18) free.

3. A manufacturing method according to Claim 2, **characterised in that** the metallic grille (18) also has a second curvature (81) able to take the thickness of the dielectric strip (60) so as to place the latter flush with the contact areas (19a) of the metallic grille (18).

4. A manufacturing method according to one of Claims 1 to 3, **characterised in that** the dielectric strip (60) consists of a polyethylene terephthalate (PET).

5. A manufacturing method according to one of Claims 1 to 3, **characterised in that** the dielectric strip (60) consists of an acrylonitrile-butadienestyrene (ABS).

6. A manufacturing method according to one of Claims 1 to 3, **characterised in that** the dielectric strip (60) consists of paper.

7. A manufacturing method according to one of Claims 1 to 3, **characterised in that** the dielectric strip (60) consists of a polyvinyl chloride (PVC).

8. A manufacturing method according to one of the preceding claims, **characterised in that** the dielectric strip (60) comprises an adhesive surface able to provide the gluing of the chip (10) to the strip (60).

9. A manufacturing method according to one of the preceding claims, **characterised in that** reference holes and/or targets are produced on the dielectric strip (60) so as to effect a precise gluing of the chip (10) on the strip (60).

10. A manufacturing method according to one of Claims 1 to 9, **characterised in that** the connection of the contact pads (11) of the chip (10) to the connection areas (19b) of the grille (18) is effected by laser welding.

11. A manufacturing method according to one of Claims 1 to 9, bumps of conductive polymer material being deposited on the contact pads (11) on the chip (10), **characterised in that** the connection of the contact pads (11) on the chip (10) to the connection areas (19b) on the grille (18) is effected by hot lamination.

12. A manufacturing method according to one of Claims 1 to 11, **characterised in that** it comprises a step of attaching the micromodule (100) in the cavity of a card body.

13. A manufacturing method according to Claim 12, **characterised in that** the attachment of the micromodule (100) is effected by activation of an adhesive film (25) previously laminated on the surface of the metallic grille (18).

14. A manufacturing method according to Claim 13, **characterised in that** the adhesive film (25) also constitutes an insulant providing the protection of the chip (10).

15. A manufacturing method according to one of Claims 1 to 11, **characterised in that** it comprises a step of connecting the micromodule (100) to an antenna (50).

16. A manufacturing method according to Claim 15, **characterised in that** the chip (10) is protected by the lamination of an insulating film (26) over the entire surface of the metallic grille (18).

17. A manufacturing method according to Claim 15, **characterised in that** the device is manufactured with an antenna (50) with central turns where the insulation of the central turns is provided by the dielectric strip (60).

18. An integrated-circuit electronic module comprising an integrated circuit chip (10) attached to a dielectric support (60) and connected to a metallic grille (18) which comprises contact areas (19a) and connection areas (19b); this module comprising a housing (85) for a chip (10) on a metallic grille (18) produced by curvature (80); this housing (85) having dimensions making it possible to receive the thickness of the chip (10) and its contact pads (11) so that the latter are flush; the grille (18) being laminated on the dielectric support (60) so that each contact pad (11) on the chip (10) is facing and in connection with the connection areas (19b) on the grille (18); **characterised in that** the chip (10) is disposed on the dielectric support whilst forming an assembly; this assembly being laminated on the metallic grille (18) in strip form, so that the protection of the chip (10) is provided by the grille (18) and the laminated support (60).

19. An electronic module according to Claim 18, **characterised in that** the dielectric support (60) consists of a strip leaving the contact areas (19a) free.

20. An electronic module according to Claim 19, **characterised in that** the metallic grille (18) has two distinct curvatures, a first curvature (80) taking the thickness of the chip (10) and its contact pads (11) and a second curvature (81) taking the thickness of the dielectric strip (60).

21. An electronic module according to one of Claims 18 to 20, **characterised in that** a protective film (25) is disposed over the entire surface of the metallic grille (18).

22. A portable integrated-circuit device such as a smart card or an electronic label comprising an electronic module according to one of Claims 18 to 21.

## Patentansprüche

1. Herstellungsverfahren einer tragbaren elektronischen Vorrichtung mit auf einen dielektrischen Träger (60) übertragenen und an ein Metallgitter (18), das Kontaktbereiche (19a) und Verbindungsbereiche (19b) umfasst, angeschlossenem integriertem Schaltkreis-Chip (10); dieses Verfahren beinhaltet eine in der Realisierung einer Aufnahme (85) durch Krümmung für Chips (10) auf dem Metallgitter (18) bestehende Stufe; wobei diese Aufnahme (85) die Aufnahme der Stärke des Chips (10) und seiner Kontaktplots (11) erlaubende Abmessungen hat, damit jene bündig eingelassen sind; das Gitter (18) wird auf dem dielektrischen Träger (60) derart aufgewalzt, dass jeder Kontaktplot (11) des Chips (10) in Verbindung mit den Verbindungsbereichen (19b) des Gitters (18) ist und ihnen gegenüber liegt; wobei dieses Verfahren **dadurch gekennzeichnet ist, dass** es ohne Unterbrechung in Linie realisiert wird, wobei der Chip (10) auf dem dielektrischen Träger als Band angeordnet wird, um einen Aufbau zu bilden; anschließend wird dieser Aufbau auf dem Metallgitter (18) als Band derart aufgewalzt, dass der Schutz des Chips (10) durch das Gitter (18) und den aufgewalzten Träger (60) gewährleistet ist.

2. Herstellungsverfahren gemäß Anspruch 1, **dadurch gekennzeichnet, dass** der dielektrische Träger (60) aus einem die Kontaktbereiche (19a) des Metallgitters (18) freilassenden Band gebildet wird.

3. Herstellungsverfahren gemäß Anspruch 2, **dadurch gekennzeichnet, dass** das Metallgitter (18) darüber hinaus eine zweite Krümmung (81) aufweist, die geeignet ist, die Stärke des dielektrischen Bandes (60) derart einzufassen, dass letzteres bündig mit den Kontaktbereichen (19a) des Metallgitters (18) platziert wird.

4. Herstellungsverfahren gemäß Anspruch 1 bis 3, **dadurch gekennzeichnet, dass** das dielektrische Band (60) aus einem Polyethylenterephtalat (PET) gebildet wird.

5. Herstellungsverfahren gemäß Anspruch 1 bis 3, **dadurch gekennzeichnet, dass** das dielektrische Band (60) aus einem Acrylnitril-Budadien-Styrol (ABS) gebildet wird.

6. Herstellungsverfahren gemäß Anspruch 1 bis 3, **dadurch gekennzeichnet, dass** das dielektrische Band (60) aus Papier gebildet wird.

7. Herstellungsverfahren gemäß Anspruch 1 bis 3, **dadurch gekennzeichnet, dass** das dielektrische Band (60) aus einem Polyvinylchlorid (PVC) gebildet wird.

8. Herstellungsverfahren gemäß einem der vorherigen Ansprüche, **dadurch gekennzeichnet, dass** das dielektrische Bank (60) eine Haftfläche umfasst, die geeignet ist, das Verkleben des Chips (10) auf dem Bank (60) zu gewährleisten.

9. Herstellungsverfahren gemäß einem der vorherigen Ansprüche, **dadurch gekennzeichnet, dass** Markierungslöcher und / oder -schlitze auf dem dielektrischen Bank (60) derart realisiert sind, dass ein präzises Verkleben des Chips (10) auf dem Band (60) ausgeführt wird.

10. Herstellungsverfahren gemäß Anspruch 1 bis 9, **dadurch gekennzeichnet, dass** die Verbindung der Verbindungsplots (11) des Chips (10) mit den Verbindungsbereichen (19b) des Gitters (18) durch Laserschweißen erfolgt.

11. Herstellungsverfahren gemäß Anspruch 1 bis 9, wobei Buckel aus leitendem Polymermaterial auf den Kontaktplots (11) des Chips (10) realisiert werden, **dadurch gekennzeichnet, dass** die Verbindung der Kontaktplots (11) des Chips (10) mit den Verbindungsbereichen (19b) des Gitters (19) durch Heißwalzen realisiert wird.

12. Herstellungsverfahren gemäß Anspruch 1 bis 11, **dadurch gekennzeichnet, dass** es eine Übertragungsstufe des Mikromoduls (100) in die Aushöhlung eines Kartenkörpers umfasst.

13. Herstellungsverfahren gemäß Anspruch 12, **dadurch gekennzeichnet, dass** die Übertragung des Mikromoduls (100) durch Aktivierung eines zuvor auf die Fläche des Metallgitters (18) aufgewalzten Haftfilms (25) realisiert wird.

14. Herstellungsverfahren gemäß Anspruch 13, **dadurch gekennzeichnet, dass** der Haftfilm (25) darüber hinaus ein den Schutz des Chips (10) gewährleistendes Isoliermittel bildet.

15. Herstellungsverfahren gemäß Anspruch 1 bis 11, **dadurch gekennzeichnet, dass** es eine Verbindungsstufe des Mikromoduls (100) mit einer Antenne (50) beinhaltet.

16. Herstellungsverfahren gemäß Anspruch 15, **dadurch gekennzeichnet, dass** der Chip (10) durch Aufwalzen eines Isolierfilms (26) auf die gesamte Fläche des Metallgitters (18) geschützt wird.

17. Herstellungsverfahren gemäß Anspruch 15, **dadurch gekennzeichnet, dass** die Vorrichtung mit Antenne (50) mit zentralen Windungen hergestellt wird, bei denen die Isolation der zentralen Windungen durch das dielektrische Bank (60) gewährleistet wird.

18. Elektronisches Modul mit integriertem Schaltkreis mit einem auf einen dielektrischen Träger (60) übertragenen und an ein Metallgitter (18), das Kontaktbereiche (19a) und Verbindungsbereiche (19b) umfasst, angeschlossenen, integrierten Schaltkreis-Chip (10); wobei dieses Modul eine durch Krümmung (80) realisierte Aufnahme (85) für Chips (10) auf einem Metallgitter (18) beinhaltet; wobei diese Aufnahme (85) die Aufnahme der Stärke des Chips (10) und seiner Kontaktplots (11) erlaubende Abmessungen hat, damit letztere bündig eingelassen sind; wobei das Gitter (18) auf dem dielektrischen Träger (60) derart aufgewalzt wird, dass jeder Kontaktplot (11) des Chips (10) gegenüber den Verbindungsbereichen (19b) des Gitters (18) liegt und mit ihnen verbunden ist ist; **dadurch gekennzeichnet, dass** der Chip (10) einen Aufbau bildend auf dem dielektrischen Träger angeordnet ist; wobei dieser Aufbau auf dem Metallgitter (18) als Band derart aufgewalzt wird, dass der Schutz des Chips (10) durch das Gitter (18) und den aufgewalzten Träger (60) gewährleistet wird.

19. Elektronisches Modul gemäß Anspruch 18, **dadurch gekennzeichnet, dass** der dielektrische Träger (60) aus einem die Kontaktbereiche (19a) freilassenden Band gebildet wird.

20. Elektronisches Modul gemäß Anspruch 19, **dadurch gekennzeichnet, dass** das Metallgitter (18) zwei unterschiedliche Krümmungen aufweist, wobei eine erste Krümmung (80) die Stärke des Chips (10) und seiner Kontaktplots (11) einfasst und eine zweite Krümmung (81) die Stärke des dielektrischen Bandes (60) einfasst.

21. Elektronisches Modul gemäß Anspruch 18 bis 20, **dadurch gekennzeichnet, dass** ein Schutzfilm (25) auf der gesamten Fläche des Metallgitters (18) angeordnet ist.

22. Tragbare Vorrichtung mit integriertem Schaltkreis, wie zum Beispiel eine Chipkarte, ein ein elektronisches Modul gemäß Anspruch 18 bis 21 umfassendes elektronisches Etikett.
